# EUROPÄISCHE PATENTANMELDUNG

(11) **EP 1 953 846 A1**
(43) Veröffentlichungstag der Anmeldung: **06.08.2008**
(21) Anmeldenummer: 08150675.0
(22) Anmeldetag: 25.01.2008
(51) Int. Cl.: H01L 51/56

(54) **Verfahren zur Strukturierung elektrolumineszenter organischer Halbleiterelemente, elektrolumineszentes organisches Halbleiterelement sowie Anordnung zur Strukturierung eines solchen Elements**

(30) Priorität: 31.01.2007 DE 102007004890; 05.04.2007 DE 102007016638
(71) Anmelder: OSRAM Opto Semiconductors GmbH, 93055 Regensburg (DE)
(72) Erfinder: Heuser, Karsten, 91056, Erlangen (DE); Buchhauser, Dirk, 10250, Georgetown (MY); Weiß, Oliver, 91054, Erlangen (DE); Sarfert, Wiebke, 91074, Herzogenaurach (DE); Tschamber, Carsten, 22765, Hamburg (DE); Gärditz, Christoph, 91052, Erlangen (DE)
(74) Vertreter: Epping - Hermann - Fischer

(57) **Zusammenfassung**

In einem Verfahren zur Strukturierung elektrolumineszenter organischer Halbleiterelemente wird ein solches mit einer ersten Elektrode (3) einer zweiten Elektrode (2) sowie einer dazwischen angeordneten organischen lichtemittierenden Schicht (1) bereitgestellt. Zur Strukturierung werden Bereiche der organischen Schicht (1) mittels thermischer Einwirkung auf die organische Schicht (1) selektiv zerstört. Die durch die thermische Einwirkung insbesondere mithilfe eines Laserstrahls zerstörten Gebiete zeigen im Betrieb des organischen Halbleiterelementes keine Elektrolumineszenz mehr. Dadurch lässt sich auch auf großflächigen Halbleiterelementen flexibel und mit geringen Kosten eine Strukturierung erreichen.

## Beschreibung

Diese Patentanmeldung beansprucht die Priorität der deutschen Patentanmeldungen 10 2007 004 890.6 und 10 2007 016 638.0, deren Offenbarungsgehalt hiermit durch Rückbezug aufgenommen wird.

Die Erfindung betrifft ein Verfahren zur Strukturierung elektrolumineszenter organischer Halbleiterelemente. Die Erfindung betrifft weiterhin ein elektrolumineszentes organisches Halbleiterelement sowie eine Anordnung zur Strukturierung eines elektrolumineszenten, organischen Halbleiterelements.

Die zunehmende Verwendung von Bildschirmen, auch in Kleinkonsumer- und Kleinstkonsumerprodukten führen zu einem steigenden Druck, die Herstellungskosten für derartige Kleinbildschirme zu senken. Darüber hinaus steigt der Bedarf an Leuchtmitteln mit einem vorbestimmten Lichtmuster. Bildschirme auf der Basis organischer lichtemittierender Dioden, den so genannten OLED's erfreuen sich hierzu wachsender Beliebtheit, da sie eine hohe Leuchtkraft bei gleichzeitig geringem Stromverbrauch und niedrigen Herstellungskosten beinhalten. Ihre große Flexibilität und verschiedenen Einsatzmöglichkeiten sowie das Merkmal auch unter niedrigen Blickwinkeln noch einen ausreichenden Kontrast zu ermöglichen, sind weitere Vorteile für elektrolumineszente organische Halbleiterelemente.

Die Basisstruktur einer organischen Leuchtdiode umfasst ein Paar Elektroden zur Ladungsträgerinjektion in ein dazwischen angeordnetes organisches lichtemittierendes Material. Das organische Material selbst, auch als OLED-Stack bezeichnet, kann seinerseits ebenfalls aus mehreren Teilschichten bestehen. In einer dieser organischen Schichten erfolgt die Lichterzeugung durch Ladungsträgerrekombination der Löcher mit den Elektronen. Weitere Teilschichten dienen zum Transport der Ladungsträger beziehungsweise einer Begrenzung möglicher Exzitonendiffusion.

Zur Ladungsträgerinjektion werden die beiden Elektroden als Anode beziehungsweise Kathode verwendet. Sehr häufig wird als Anodenmaterial ein leitfähiges und transparentes Metalloxid beispielsweise Indium-dotiertes Zinnoxid oder Indium-dotiertes Zinkoxid verwendet. Dieses wird auf einem Substratträger meist aus Glas oder einer transparenter Plastikfolie mittels Abscheiden, Spattern oder anderen Prozessen aufgebracht. Abhängig von dem verwendeten organischen Material sind verschiedene Herstellungsprozesse der lichtemittierenden Schicht möglich. Bei organischen Polymeren finden häufig Abscheidungsprozesse mit Lösungsmitteln durch Spinnen, Schleudern, Sprühen oder Drucken Verwendung. Bei lösungsmittelfreien Herstellungsverfahren wird häufig Gasphasenepitaxie oder OVPD verwendet.

Zur Herstellung der Kathode auf der Oberfläche des auf der Anode abgeschiedenen organischen Materials werden Metallverbindungen als Tunnelbarrieren, beispielsweise LiF, CaF oder elementare Metallschichten aufgebracht.

Da sowohl die organischen Materialien als auch die verwendeten Elektroden gegebenenfalls durch den Luftsauerstoff beziehungsweise durch Wasser oxidierbar sind, werden die organischen Halbleiterelemente nach der Herstellung durch zusätzlich inhärente Schichten versiegelt.

Zur Herstellung einer Struktur für die elektrolumineszenten organischen Halbleiterelemente beispielsweise zur Darstellung einer Form oder einer Figur wird zumindest eine der verwendeten Elektrode mithilfe fotolithografischer Prozesse während des Herstellungsverfahrens strukturiert. Für die Herstellung von Bildschirmen mit adressierbaren Pixeln bietet es sich beispielsweise an, die Anode in Spalten und die Kathode in Reihen zu strukturieren, so dass die überlappenden Bereiche jeweils separat adressierbare Pixel spezifizieren. Bei Bildschirmen beziehungsweise elektrolumineszenten organischen Halbleiterelementen zur Darstellung bestimmter Figuren ist dieser Prozess jedoch kompliziert und führt zu einem erhöhten Kostenaufwand.

Es besteht demnach das Bedürfnis, die Kosten für den Herstellungsprozess derartiger elektrolumineszenter organischer Halbleiterelemente zu reduzieren und gleichzeitig eine möglichst hohe Flexibilität bei der Strukturierung zu gewährleisten.

Diese Aufgabe wird mit den Gegenständen der unabhängigen Patentansprüche 1, 17 und 21 gelöst. Ausgestaltungen und Weiterbildungen sind Gegenstand der Unteransprüche.

Erfindungsgemäß ist ein Verfahren zur Strukturierung elektrolumineszenter organischer Halbleiterelemente vorgesehen, bei der nicht mehr die Elektroden, sondern die zwischen den Elektroden befindliche lichtemittierende Schicht nach einer Herstellung des elektrolumineszenten Bauelements strukturiert wird. Dies erfolgt erfindungsgemäß dadurch, dass Bereiche der organischen Schicht mittels thermischer Einwirkung auf die organische Schicht selektiv zerstört werden. Dadurch wird die lichtemittierende Schicht lokal zerstört, sodass keine weitere Elektrolumineszenz stattfindet. Unter Zerstörung eines lokalen Teilbereichs kann eine thermisch induzierte chemische Umwandlung der organischen Verbindungen verstanden werden, die dadurch ihre Lumineszenzeigenschaft verlieren. Alternativ kann nach einer Herstellung eines unstrukturierten elektrolumineszenten organischen Halbleiterelements eine oder beide Elektroden mittels thermischer Einwirkung strukturiert werden. Dadurch wird der Widerstand der Elektroden in diesen Teilbereichen verändert, so dass dieser, stark erhöht, die Ladungsträgerinjektion an diesen Stellen unterbindet bzw. herabsetzt.

So erlaubt die selektive Zerstörung von Bereichen der organischen Schicht eine flexible und im Wesentlichen freie Erzeugung verschiedenartiger Strukturen für die elektrolumineszenten organischen Halbleiterelemente. Dadurch können beispielsweise einfache Figuren leicht und ohne kostenaufwändiges fotolithografisches Verfahren hergestellt werden. Insbesondere lassen sich die Elektroden oder die organische Schicht nach einer Herstellung des Bauelements und einer Umhüllung mit einer transparenten Schutzschicht zur Verhinderung einer Oxidation mit dem erfindungsgemäßen Verfahren strukturieren.

In einer Ausgestaltung der Erfindung erfolgt das selektive Zerstören mittels thermischer Einwirkung durch einen auf die organische Schicht fokussierten Lichtstrahl. Dieser kann von einem Laser als kohärenter Strahl erzeugt werden. Ebenso lässt sich aber auch nicht kohärentes Licht verwenden, das durch eine geeignete Optik fokussiert wird.

Damit wird in einer Ausgestaltung der Erfindung die organische Schicht durch zusätzliche äußere Lichteinwirkung selektiv in Bereichen zerstört. Die Verwendung eines Laserstrahls ist dabei von Vorteil, da dieser kohärentes Licht vordefinierter Wellenlänge auf einen kleinen Bereich fokussieren kann und somit auch kleine Strukturen fehlerfrei erzeugt werden können. Für die Herstellung großflächiger Strukturen können fokussierte inkohärente Lichtstrahlen benutzt werden, die thermisch auf die gewünschten Bereiche einwirken, so dass ein elektrolumineszentes Verhalten zerstört wird. In einer anderen Ausgestaltung wird wenigstens eine der beiden Elektroden nach einer Herstellung des elektrolumineszenten organischen Halbleiterelements selektiv in Teilbereichen durch thermische Einwirkung zerstört und damit das Element strukturiert.

Der Laserstrahl beziehungsweise das verwendete Licht kann im sichtbaren Wellenlängenspektrum beziehungsweise im nahen Infrarotspektrum liegen. Insbesondere ist es zweckmäßig, wenn wenigstens eine Elektrode des elektrolumineszenten organischen Halbleiterelementes für das verwendete Licht transparent ist und mit diesem möglichst wenig in Wechselwirkung tritt. Für die Strukturierung wird das Licht durch die Elektrode auf die organische Schicht fokussiert. Dadurch wird einerseits ein thermisches Aufheizen des gesamten Elementes verhindert und andererseits eine bessere Strukturierung erreicht.

In einer Weiterbildung der Erfindung kann zudem die transparente Elektrode beziehungsweise das transparente Material, welches die lichtemittierende Schicht umgibt zur Fokussierung des Lichtes auf die Bereiche der organischen Schicht genutzt werden. Das für den Prozess des selektiven Zerstörens verwendete Licht kann kontinuierlich oder gepulst erzeugt werden. Zur Strukturierung kann es zweckmäßig sein, das organische Halbleiterelement unter dem Lichtstrahl oder den Lichtstrahl über die organische Schicht zu bewegen. Ebenso ist eine Kombination aus beiden möglich, wodurch mit Vorteil großflächige Strukturen organischer elektrolumineszenter Halbleiterelemente in einer Fertigungsstraße herstellbar sind.

Im Folgenden wird die Erfindung unter Zuhilfenahme der Zeichnungen im Detail erläutert.

Es zeigen:
Figur 1 ein erstes Ausführungsbeispiel der Erfindung,
Figur 2 eine zweite Ausgestaltungsform der Erfindung,
Figur 3 eine schematische Darstellung eines Systems zur Strukturierung organischer Schicht in elektrolumineszenten organischen Halbleiterelementen.

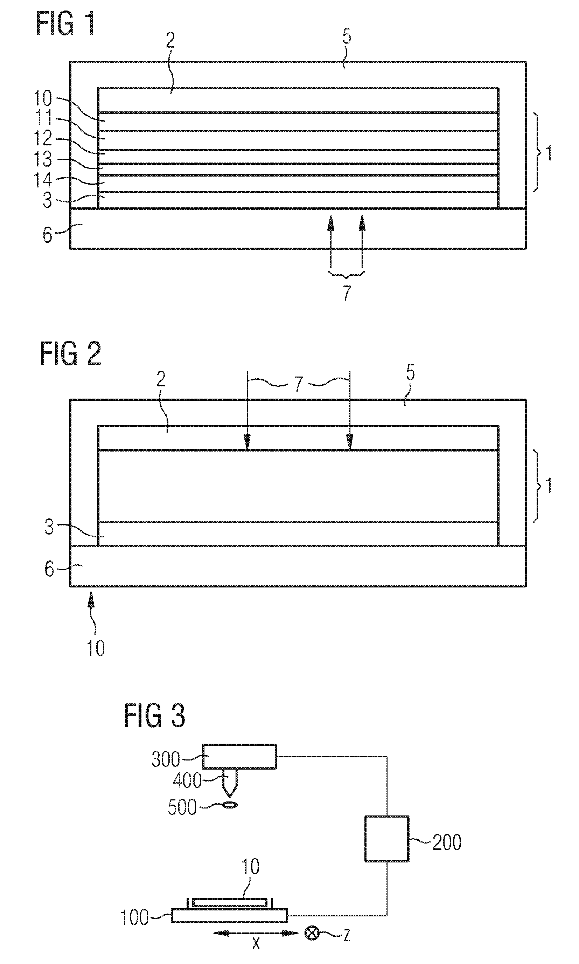

Figur 1 zeigt eine Ausgestaltungsform einer organischen Leuchtdiode (OLED), welcher als so genannter Bottom-Emitter mit einem transparenten Glassubstrat 6 sowie einer transparenten ersten Elektrode 3 ausgebildet ist. Die Elektrode 3 als Anode umfasst eine Schicht aus einem transparenten leitfähigen Metalloxid und dient zur flächigen Verteilung der Ladungsträger auf den OLED-Stack 1. Als Material der Elektrode 3 kommt beispielsweise Indium-dotiertes Zinnoxid beziehungsweise Indium-dotiertes Zinkoxid zum Einsatz. Zur Verbesserung der Leitfähigkeit kann dieses zusätzlich durch dünne Leitungsabschnitte aus hoch leitfähigem Metall "geshuntet" werden. Das leitfähige Metalloxid wird in einem ersten Herstellungsschritt auf dem Glassubstrat 6 abgeschieden. Die Dicke beträgt ca. 1µm kann aber abhängig von dem Material auch dicker oder dünner sein. Typischerweise kann sie ca. 100 nm bis 200 nm betragen. Anschließend wird der OLED-Stack 1 auf der Anode 3 hergestellt.

Der OLED-Stack 1 umfasst eine Vielzahl einzelner Teilschichten 10 bis 14 aus verschiedenen organischen Materialien. Die Schichten 13 und 14 dienen dazu die von der Anode bereitgestellten Ladungsträger in die lichtemittierenden Schichten 11, 12 zu transportieren sowie die von der Kathode 2 initiierten Elektronen abzublocken und in den Teilschichten 11, 12 zu halten. Darüber hinaus begrenzen die Teilschichten 10, 13 und 14 eine Exzitonendiffusion, so dass die Rekombinationseffizienz und damit die Photonengeneration erhöht werden. Im Einzelnen wird auf der Anode 3 eine erste Schicht aus 1-TNATA abgeschieden. Auf diese wird eine Schicht aus S-TAD aufgebracht. Anschließend werden drei Teilschichten 12, 11 und 10 abgeschieden. Die Schichten 11 und 12 umfassen ein lichtemittierendes organisches Material. Die verwendeten Materialien in den Teilschichten 11 und 12 sind jedoch unterschiedlich erzeugen bei einer Ladungsträgerrekombination Licht unterschiedlicher Wellenlänge. Dadurch ergibt sich ein Farbgemisch. Bei der Verwendung von drei Schichten, die im roten, blauen und grünen Spektrum Licht erzeugen, lässt sich weißes Licht erzeugen.

Im Einzelnen besteht die Teilschicht 12 aus dem Material SEB-010/SEB020 und erzeugt Photonen im blauen Bereich des Spektrums. Die Teilschicht 11 umfasst das Material TMM-004:LR(ppy)3(15%) und dient zur Erzeugung eines grünen Lichts. Licht im roten Spektrum könnte beispielsweise durch eine Teilschicht mit dem Material TMM-04:TER012 erzeugt werden. Die Teilschicht 10, die über den Schichten 11 und 12 angeordnet ist, blockiert den Löchertransport und verbessert die Elektroneninjektion in die elektrolumineszenten Schichten 11, 12. Die dargestellte Anordnung aus den Teilschichten 10 bis 14 in der vertikalen Anordnung ist als so genannter Bottom-Emitter mit einer Emissionsrichtung des abgestrahlten Lichts auf das Glassubstrat 6 hin ausgebildet. Die Anordnung aus den lichtemittierenden Teilschichten führt dazu, dass die in der Teilschicht 11 erzeugten Photonen nicht durch die Teilschicht 12 wieder reabsorbiert werden.

Zur Elektroneninjektion ist letztlich auf der obersten Teilschicht 10 des OLED-Stacks 1 die Kathode 2 aufgebracht. Diese besteht aus einer Kombination eines Metallhalogens, beispielsweise Barium-, Kalzium- oder Lithiumflorid und einer aufgedampften leitfähigen Schicht aus Aluminium beziehungsweise Silber zur Verbesserung des lateralen Widerstands. Daneben kann auch ein anderes reaktives Metall mit niedriger Austrittsarbeit wie beispielsweise Barium, Calcium oder Magnesium als Kathodenmaterial verwendet werden. Zur Verhinderung einer Oxidation ist der gesamte OLED-Stack einschließlich der Kathode 2 und Anode 3 von einer Schutzummantelung 5 umgeben. Diese kann beispielsweise aus einem zweiten Glasmaterial oder auch aus einer Plastik bestehen. Unter anderem ist auch eine Dünnfilmverkapselung geeignet, die mehrere Lagen aus einer dünnen Oxidschicht und organischen bzw. polymeren Planarisierungsschichten umfasst.

Der hier dargestellte Herstellungsprozess erfolgt ohne eine aufwändige Strukturierung der Elektroden beziehungsweise der einzelnen Schichten des OLED-Stacks. Im Betrieb leuchtet das unstrukturierte Element gleichmäßig. Eine Strukturierung der organischen Halbleiterdiode beziehungsweise des elektrolumineszenten organischen Halbleiterelementes wird nun mithilfe eines fokussierten Laserstrahls 7 durchgeführt, der von außen durch das Glassubstrat 6 und die Elektrode 3 auf die einzelnen Schichten des OLED-Stacks 1 fokussiert wird. Die Wellenlänge des verwendeten Laserstrahls 7 ist dabei so gewählt, dass diese von den lichtemittierenden Teilschichten 11 und 12 möglichst gut absorbiert wird. Die hohe Absorption in den Teilschichten 11 und 12 führt zu einer starken lokalen thermischen Erwärmung, wodurch die chemischen Verbindungen aufgebrochen und neue Verbindungen hergestellt werden. Das chemisch umgewandelte Material besitzt dann in den bestrahlten Teilbereichen keine Lumineszenz. Vereinfacht ausgedrückt wird die Struktur in den von dem Laserstrahl getroffenen Bereichen innerhalb der Teilschichten zerstört. Entsprechend zeigen die von dem Laserstrahl getroffenen und erhitzten Bereiche der Teilschichten 11 und 12 im Betrieb des Halbleiterelementes keine Elektrolumineszenz mehr. Auf diese Weise kann ein unstrukturiertes elektrolumineszentes organisches Halbleiterelement, dessen Herstellungsprozess bereits abgeschlossen ist, nachträglich strukturiert werden. Beispielsweise können Figuren beziehungsweise Zeichen in die einzelnen organischen Teilschichten gebrannt werden, ohne dass dies bereits während des Herstellungsprozesses mithilfe aufwändiger Masken und fotolithografischer Verfahren notwendig wäre.

In dem hier dargestellten Beispiel, bei dem alle beiden lichtemittierenden Teilschichten 11 und 12 selektiv zerstört werden ist es auch möglich, den Laserstrahl 7 wellenlängenabhängig nur auf bestimmte Teilschichten des OLED-Stacks zu richten. Beispielsweise kann eine Wellenlänge für den Laserstrahl gewählt werden, die nur in einer der Teilschichten des OLED-Stacks absorbiert wird. Dadurch lässt sich beispielsweise in der blaues Licht emittierenden Teilschicht 12 eine erste Struktur realisieren, während in der weiteren lichtemittierende Teilschicht 11 andere Strukturen erzeugt werden. Im Ergebnis ist so eine Herstellung verschiedenfarbiger elektrolumineszenter Halbleiterelemente möglich.

Alternativ kann auch nicht nur die lichterzeugende Schicht, sondern auch darüber oder darunter befindlichen Schichten 10 bzw. 13 und 14 selektiv zerstört werden. Dies ist dann sinnvoll, wenn eine Fokussierung nur unzureichend möglich wäre oder die Schichten besonders gut Licht einer bestimmten Wellenlänge absorbieren. Auch kann anstatt der organischen Schichten eine Elektrode oder sogar beide Elektroden mittels thermischer Einwirkung strukturiert werden. Dies würde die organische Schicht selbst vor einer selektiven Zerstörung weitgehend bewahren. Dennoch wird ein strukturiertes Lichtmuster erzeugt, das die Elektroden im beschädigten oder zerstörten Bereiche keine Ladungsträger mehr in den Stack injizieren. Ebenso können in die verschiedenen Schichten selektiv unterschiedliche Strukturen gefertigt werden, um auch komplexe Muster zu erhalten.

In einer anderen Ausgestaltung der Erfindung bietet es sich an das Glassubstrat beziehungsweise die Anode 3 zur Fokussierung des Laserstrahls 7 mit zu verwenden. Abhängig von einer möglichen Krümmung des Glassubstrates 6 beziehungsweise der Elektrode 3 oder des verwendeten Materials können Aparationseffekte während des Strukturierungsprozesses durch das Glassubstrat 6 oder die Elektrode 3 ausgenutzt werden.

Figur 2 zeigt eine weitere Ausführungsform der Erfindung. In dieser besteht der OLED-Stack 1 aus einer einzelnen lichtemittierenden Schicht. Zwischen dem Glassubstrat 6 und der Anode 3 ist eine dünne reflektierende Metallschicht aufgebracht. Diese verbessert zum einen die Elektroneninjektion und dient zur Verringerung des Flächenwiderstandes der Elektrode 3 aus dem Metalloxid. Zum anderen wird von den organischen Schichten erzeugtes Licht wieder in die gewünschte Abstrahlrichtung reflektiert. Auf der Oberseite des OLED-Stacks 1 ist die Kathode 2 aus einem transparenten Material abgeschieden. Wiederum ist das elektrolumineszente organische Halbleiterelement 10 von einer Schutzschicht 5 aus transparentem Material umgeben. Im Betrieb der hier dargestellten organischen Leuchtdiode wird das in der organischen Schicht 1 erzeugte Licht durch die Oberseite ausgekoppelt. Man spricht daher auch von einem Top-Emitter.

Zur Strukturierung der organischen Leuchtdiode wird in dieser Ausführung ein fokussierter Lichtstrahl durch die Oberseite der Schutzschicht 5 der Kathode 2 und der organischen Schicht 1 zugeführt. Die lokale thermische Erwärmung führt zu einer Zerstörung der Elektrolumineszenz in diesen Bereichen. Die gewünschte Struktur selbst kann durch eine entsprechende Bewegung des Halbleiterelementes bezüglich eines festen Lichtstrahls 7 beziehungsweise durch eine Bewegung des Lichtstrahls 7 zu einem fixierten Halbleiterelement erfolgen. Eine weitere Möglichkeit besteht darin, mit Hilfe einer abbildenden Optik die gewünschte Struktur direkt in die organische Schicht 1 einzubrennen. Eine schematische Darstellungsform für ein System zur Verwendung der unterschiedlichen Herstellungsmöglichkeiten zeigt Figur 3.

Hierbei ist auf einem beweglichen Positioniertisch 100 das organisch lumineszente Halbleiterelement 10 fixiert. Das Halbleiterelement 10 kann Bestandteil eines großflächigeren Wafers sein, auf dem eine Vielzahl von Halbleiterelementen angeordnet ist. Auch kann der Positioniertisch 100 Teil einer Fertigungsstraße sein. Die zu strukturierenden Elemente fahren dann langsam unter der Strukturierungsvorrichtung hindurch. Dadurch werden großflächige organische Halbleiterelemente auf einfache Weise strukturiert.

Die Halterung 100 ist bezüglich der x-Richtung sowie der z-Richtung senkrecht zur Zeichenebene frei bewegbar. Eine Bewegung der Halterung 10 erfolgt beispielsweise über piezoelektrische Elemente im Fall einer Herstellung möglichst kleiner Strukturen beziehungsweise mithilfe genauer Schrittmotoren, sofern großflächige Halbleiterelemente strukturiert werden. Zur Steuerung der Bewegung ist die Halterung 100 an einen Computer 200 und eine Steuerungsvorrichtung angeschlossen. Das System weist ferner eine zweite Positioniereinrichtung 300 auf, welche in Wirkverbindung mit einer Laservorrichtung 400 steht. Die Positioniereinrichtung lässt sich ebenso in die verschiedenen Richtungen bewegen und leicht schwenken. Die Laservorrichtung umfasst beispielsweise einen Neodym:YAG-Laser zur Erzeugung von Licht im nahen infraroten beziehungsweise über Frequenzverdoppelung im sichtbaren Bereich des Spektrums. Auch andere Laserarten beispielsweise Diodenlaser, Helium-Neon-Laser oder Farbstofflaser können hier zum Einsatz kommen. Der von dem Laser 400 erzeugte Strahl wird über eine Optik 500 auf das organische Halbleiterelement und im Besonderen auf die lichtemittierende Schichtfolge innerhalb des Halbleiterelementes fokussiert. Mit dem Fokus in einer der Teilschichten des organischen Halbleiterelements wird diese erwärmt und thermisch zerstört. Dabei kann der Fokuspunkt sowohl in den Elektroden als auch in Teilschichten des organischen OLED-Stacks liegen.

Durch die thermische Erwärmung werden nunmehr Bereiche selektiv zerstört, sodass diese im Betrieb des Halbleiterelementes keine Elektrolumineszenz mehr zeigen. Dadurch lassen sich im Betrieb sichtbare Strukturen im Halbleiterelement erzeugen. Während der Strukturierung wird der Laser abhängig von der gewünschten Leistung beziehungsweise der vorzunehmenden Strukturierung in einer gepulsten oder einer kontinuierlichen Betriebsart verwendet. Dabei ist sicherzustellen, dass die in den lichtemittierenden Schichten deponierte Energie des Lasers nur zu einer selektiven und lokalen Zerstörung in den gewünschten Bereichen der lichtemittierenden organischen Schicht führt. Die Steuerung des Lasers 400 zur Erzeugung einer Struktur innerhalb des Halbleiterelementes wird über den Computer 200 und die verschiedenen Positionierungseinrichtungen 100 und 300 vorgenommen. Diese bewegt sich entlang der X-beziehungsweise Z-Richtung, bis die gewünschte Struktur fertig gestellt ist.

Daneben besteht auch die Möglichkeit, die Optik 500 durch eine bewegliche Spiegeloptik zu ersetzen. Diese kann beispielsweise durch piezoelektrische Elemente betrieben werden, wodurch eine sehr schnelle Ausrichtung des Lichtstrahls erfolgt. Da durch eine starke Bewegung sich der Fokuspunkt des Lichtes innerhalb des Halbleiterelementes verschieben kann, ist es zweckmäßig, für eine Strukturierung auch den Positioniertisch 100 zu bewegen. Somit lassen sich besonders schnell großflächige Strukturen auf dem organischen Halbleiterelement realisieren. Durch die Steuerung mittels des Computers 200 können verschiedene Strukturen flexibel und ohne zusätzliche Masken erzeugt werden.

Darüber hinaus kann eine Strukturierung auch durch eine abbildende Optik erfolgen. So kann beispielsweise die Optik 500 mit einer die gewünschte Struktur zeigenden Schattenmaske ausgestattet sein. Ein Abbild der Schattenmaske wird dann mithilfe einer zusätzlichen Optik auf das Halbleiterelement 10 und im Besonderen in die organische Schicht des Halbleiterelementes 10 fokussiert.

Mit den hier dargestellten Verfahren können auf einfache Weise sehr flexible Strukturierungen organischer Leuchtdioden auch nach einer Fertigstellung derselben erzeugt werden. Zu diesem Zweck sind keine aufwändigen Masken und zusätzliche fotolithografische Prozesse notwendig. Damit eignet sich das dargestellte Verfahren auch für die Erzeugung von Klein- beziehungsweise Kleinstserien organischer Leuchtdioden. Insbesondere lassen sich auch individuelle organische Halbleiterelemente in unterschiedlicher Größe realisieren.

## Patentansprüche

1. Verfahren zur Strukturierung elektrolumineszenter organischer Halbleiterelemente, umfassend:
- Bereitstellen eines elektrolumineszenten organischen Halbleitelements, mit einer ersten Elektrode und einer zweiten Elektrode sowie einer zwischen ersten und zweiten Elektrode angeordneten organischen durch Ladungsträgerrekombination lichtemittierenden Schicht;
- selektives Zerstören von Bereichen wenigstens der organischen Schicht mittels thermischer Einwirkung auf die organische Schicht zum Erzeugen eines strukturierten Halbleiterelements.

2. Verfahren nach Anspruch 1, bei dem die organischen durch Ladungsträgerrekombination lichtemittierenden Schicht wenigstens eine erste lichtemittierenden Teilschicht (11, 12) und eine zweite Teilschicht (10, 13) umfasst, wobei für eine Strukturierung wenigstens eine der Teilschichten in Bereichen selektiv zerstört wird.

3. Verfahren nach einem der Ansprüche 1 bis 2, bei dem das selektive Zerstören erfolgt, in dem eine erste organische Verbindung der organischen Schicht mittels der thermischen Einwirkung in wenigstens eine zweite keine Lumineszenz zeigende Verbindung umgewandelt wird.

4. Verfahren nach einem der Ansprüche 1 bis 3, bei dem das selektive Zerstören mittels thermischer Einwirkung durch einen auf die organische Schicht fokussierten Lichtstrahl erfolgt.

5. Verfahren nach Anspruch 4, bei dem eine Wellenlänge des Lichtstrahls im sichtbaren Wellenlängensprektrum liegt.

6. Verfahren nach Anspruch 4, bei dem eine Wellenlänge des Lichtstrahls im infraroten oder im ultravioletten Wellenlängenspektrum liegt.

7. Verfahren nach einem der Ansprüche 1 bis 6, bei dem wenigstens eine Elektrode des elektrolumineszenten organischen Halbleiterelements für Licht transparent ist.

8. Verfahren nach einem der Ansprüche 3 bis 7, bei dem der Lichtstrahl während des selektiven Zerstörens von Bereichen der organischen Schicht kontinuierlich erzeugt wird.

9. Verfahren nach einem der Ansprüche 3 bis 7, bei dem der Lichtstrahl während des selektiven Zerstörens von Bereichen der organischen Schicht gepulst erzeugt wird.

10. Verfahren nach einem der Ansprüche 3 bis 9, bei dem der Lichtstrahl von einem Laser erzeugt wird.

11. Verfahren nach einem der Ansprüche 3 bis 10, bei dem während des selektiven Zerstörens der Lichtstrahl bewegt wird zur Erzeugung der Struktur in der organischen Schicht.

12. Verfahren nach einem der Ansprüche 1 bis 11, bei dem während des selektiven Zerstörens das organische Halbleiterelement bewegt wird zur Erzeugung der Struktur in der organischen Schicht.

13. Verfahren nach einem der Ansprüche 1 bis 12, bei dem ein Fokuspunkt in der organischen Schicht während des selektiven Zerstörens einen Durchmesser im Bereich von 10 bis 300 µm aufweist.

14. Verfahren nach einem der Ansprüche 1 bis 13, bei dem wenigstens eine Elektrode der ersten und zweiten Elektrode des elektrolumineszenten Halbleiterelements unstrukturiert hergestellt wird.

15. Verfahren nach einem der Ansprüche 1 bis 14, bei dem der Lichtstrahl zumindest teilweise durch die Elektroden fokussiert wird.

16. Verfahren nach einem der Ansprüche 1 bis 15, bei dem ein selektives Zerstören von Bereichen wenigstens einer der Elektroden mittels thermischer Einwirkung erfolgt.

17. Elektrolumineszentes organisches Halbleiterelement, umfassend:
- eine erste Elektrode (2) und eine zweite Elektrode (3) zur Ladungsträgerinjektion;
- wenigstens eine zwischen erster und zweiter Elektrode (2, 3) angeordnete, organische durch Ladungsträgerrekombination lichtemittierende Schicht (1);
**dadurch gekennzeichnet, dass**
wenigstens Teilbereiche der organischen Schicht (1) selektiv durch thermische Einwirkung zerstört sind.

18. Halbleiterelement nach Anspruch 17, bei dem die Schicht (1) wenigstens eine erste lichtemittierende Teilschicht (11, 12) und wenigstens eine zweite Teilschicht (10, 13, 14) umfasst, wobei wenigstens eine der Teilschichten zerstört ist.

19. Halbleiterelement nach einem der Ansprüche 17 bis 18, bei dem die durch thermische Einwirkung zerstörten Teilbereiche eine organische Verbindung aufweisen, die keine Lumineszenz zeigt.

20. Halbleiterelement nach einem der Ansprüche 17 bis 19, bei dem zusätzlich wenigstens Teilbereiche der ersten und/oder zweiten Elektrode (2, 3) selektiv durch thermische Einwirkung zerstört sind.

21. Anordnung zur Strukturierung eines elektrolumineszenten, organischen Halbleiterelements, umfassend:
- einen Positioniereinrichtung (100) mit einer Aufnahmevorrichtung für wenigstens ein elektrolumineszentes, organisches Halbleiterelement (10);
- eine Haltevorrichtung (300) mit einem Lichtmittel (400) zur Abgabe eines gerichteten Lichtstrahls;
- eine Ablenkeinrichtung (500) zwischen dem Lichtmittel (400) und der Positioniereinrichtung (100), zum Ablenken des Lichtstrahls auf das wenigstens eine elektrolumineszente, organische Halbleiterelement (10);
- wobei ein Fokuspunkt des gerichteten Lichtstrahls in einer Schicht des organischen Halbleiterelements (10) liegt zum selektiven Zerstören von Teilbereichen der Schicht mittels thermischer Einwirkung.

22. Anordnung nach Anspruch 21, bei dem das Lichtmittel (400) eine Laservorrichtung aufweist.

23. Anordnung nach einem der Anspruch 22, bei dem ein Neodym:YAG Laser mit Licht im Infraroten Spektrum oder im grünen Spektrum vorgesehen ist.

24. Anordnung nach einem der Ansprüche 21 bis 23, bei dem die Positioniereinrichtung im Wesentlichen senkrecht zum Lichtstrahl entlang wenigstens einer Richtung bewegbar angeordnet ist.

25. Anordnung nach einem der Ansprüche 21 bis 24, bei dem die die Ablenkeinrichtung eine Fokussiereinrichtung umfasst zum Fokussieren des gerichteten Lichtstrahls auf die Schicht des organisches Halbleiterelements (10).

26. Anordnung nach einem der Ansprüche 21 bis 25, bei dem die die Ablenkeinrichtung wenigstens einen bewegbare Spiegelvorrichtung umfasst durch die der Fokuspunkt des gerichteten Lichtstrahls abgelenkt wird.

27. Anordnung nach einem der Ansprüche 21 bis 26, bei dem der Fokuspunkt des gerichteten Lichtstrahls in einer licht emittierenden Teilschicht der organischen Schicht liegt.

28. Anordnung nach einem der Ansprüche 21 bis 27, bei dem die Schicht wenigstens eine der beiden Elektroden umfasst.
